# EUROPÄISCHE PATENTANMELDUNG

(11) **EP 1 170 792 A2**
(43) Veröffentlichungstag der Anmeldung: **09.01.2002**
(21) Anmeldenummer: 01115517.3
(22) Anmeldetag: 27.06.2001
(51) Int. Cl.: H01L 21/768

(54) **Metallisierungsanordnung für Halbleiterstruktur und entsprechendes Herstellungsverfahren**

(30) Priorität: 07.07.2000 DE 10034020
(71) Anmelder: Infineon Technologies AG, 81669 München (DE)
(72) Erfinder: Weber, Detlef, Dr., 01465 Grünberg (DE)
(74) Vertreter: Reinhard - Skuhra - Weise & Partner

(57) **Zusammenfassung**

Die vorliegende Erfindung schafft eine Metallisierungsanordnung für eine Halbleiterstruktur (1) mit einer ersten Unterbauebene (M1), vorzugsweise einer ersten Metallisierungsebene; einer zweiten Metallisierungsebene (M2) mit einer ersten und einer zweiten benachbarten Leiterbahn (LBA; LBB); einem ersten Zwischendielektrikum (ILD1) zur gegenseitigen elektrischen Isolation der ersten Unterbauebene (M1) und zweiten Metallisierungsebene (M2); und mit einem leitenden Material (FM) gefüllten Durchgangslöchern (V) in dem Zwischendielektrikum (ILD1) zum Verbinden der ersten Unterbauebene (M1) und zweiten Metallisierungsebene (M2). Unter der zweiten Metallisierungsebene (M2) ist eine Linerschicht (L) aus einem dielektrischen Material vorgesehen, welche im Zwischenraum (O) zwischen der ersten und zweiten benachbarten Leiterbahn (LBA; LBB) der zweiten Metallisierungsebene (M2) unterbrochen ist. Die Erfindung schafft ebenfalls ein entsprechendes Herstellungsverfahren.

## Beschreibung

Die vorliegende Erfindung betrifft eine Metallisierungsanordnung für eine Halbleiterstruktur mit einer ersten Unterbauebene, einer zweiten Metallisierungsebene mit einer ersten und einer zweiten benachbarten Leiterbahn, einem ersten Zwischendielektrikum zur gegenseitigen elektrischen Isolation der ersten Unterbauebene und zweiten Metallisierungsebene und mit mit einem leitenden Material gefüllten Durchgangslöchern in dem ersten Zwischendielektrikum zum Verbinden der ersten Unterbauebene und zweiten Metallisierungsebene. Ebenfalls betrifft die Erfindung ein entsprechendes Herstellungsverfahren.

Der Begriff Halbleiterstruktur soll im allgemeinen Sinne verstanden werden und kann daher sowohl einschichtige als auch mehrschichtige Strukturen mit beliebigen Halbleiterbauelementen umfassen. Beispielsweise ist die Halbleiterstruktur eine integrierte Schaltung, für die die Metallisierungsanordnung eine interne bzw. externe Verdrahtung vorsieht.

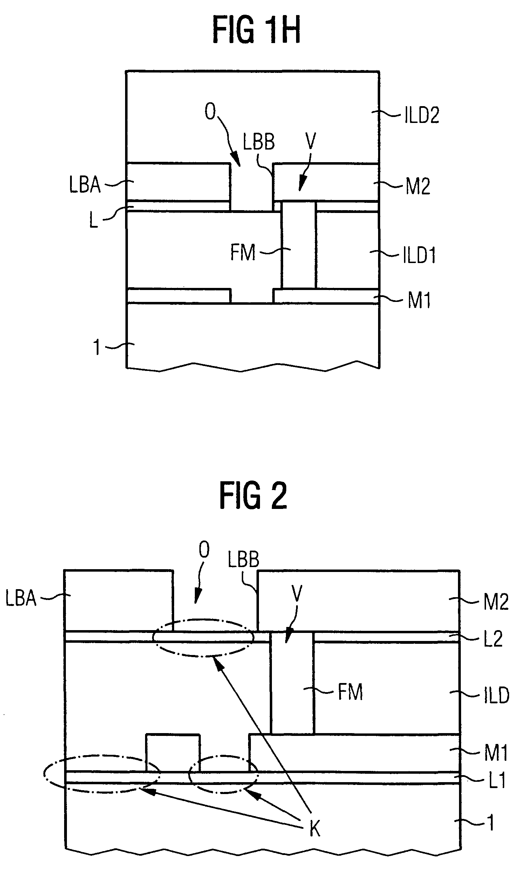

Fig. 2 zeigt eine schematische Darstellung einer bekannten Metallisierungsanordnung für eine Halbleiterstruktur.

In Figur 2 bezeichnen 1 eine Halbleiterstruktur, beispielsweise eine in einem Siliziumsubstrat integrierte elektrische Schaltung, L1 eine erste Linerschicht aus Siliziumdioxid, M1 eine erste Metallisierungsebene, ILD ein Zwischendielektrikum, V ein mit einem leitenden Material FM gefülltes Durchgangsloch, L2 eine zweite Linerschicht, M2 eine zweite Metallisierungsschicht, LBA eine erste Leiterbahn, LBB eine zweite Leiterbahn und O einen Zwischenraum zwischen der ersten und zweiten Leiterbahn LBA, LBB sowie K kritische Stellen der Struktur.

Allgemein hat die Einführung des Zwischendielektrikums ILD mit niedriger Dielektrizitätskonstante zum Ziel, die kapazitive Koppelung benachbarter Leiterbahnen zu reduzieren und damit die Funktionstüchtigkeit bei unveränderter Chipfläche zu verbessern. Die Integration des Zwischendielektrikums ILD mit niedriger Dielektrizitätskonstante erfordert im Allgemeinen jedoch die Bereitstellung der Linerschicht L1 bzw. L2, beispielsweise in Form eines Siliziumoxidliners bzw. Siliziumnitridliners, zur Strukturierung der Durchgangslöcher V und als Diffusionsbarriere ( z.B. bei einer AlCu-Metallisierung).

Die relativ hohe Dielektrizitätskonstante solch einer Linerschicht L1 bzw. L2 in Form eines Siliziumoxidliners bzw. Siliziumnitridliners wirkt sich aber negativ auf die kapazitive Koppelung benachbarter Leiterbahnen, beispielsweise LBA und LBB, aus. Solche kritischen Stellen bei der bekannten Anordnung gemäß Figur 2 sind mit K bezeichnet.

Die der vorliegenden Erfindung zu Grunde liegende Aufgabe liegt darin, die störende kapazitive Koppelung zu reduzieren.

Erfindungsgemäß wird diese Aufgabe durch das in Anspruch 1 angegebene Halbleiterbauelement und das in Anspruch 6 angegebene Herstellungsverfahren gelöst.

Gemäß der vorliegenden Erfindung ist es möglich, eine störende kapazitive Kopplung zwischen benachbarten Leiterbahnen der zweiten Metallisierungsebene erheblich zu reduzieren.

Die der vorliegenden Erfindung zugrundeliegende allgemeine Idee besteht darin, dass unter der zweiten Metallisierungsebene eine Linerschicht aus einem dielektrischen Material vorgesehen ist, welche im Zwischenraum zwischen der ersten und zweiten benachbarten Leiterbahn der zweiten Metallisierungsebene unterbrochen ist.

In den Unteransprüchen finden sich vorteilhafte Weiterbildungen und Verbesserungen des in Anspruch 1 angegebenen Halbleiterbauelements bzw. des in Anspruch 7 angegebenen Herstellungsverfahrens.

Gemäß einer bevorzugten Weiterbildung ist die erste Unterbauebene eine erste Metallissierungsebene.

Gemäß einer weiteren bevorzugten Weiterbildung wird der Zwischenraum zwischen der ersten und zweiten benachbarten Leiterbahn der zweiten Metallisierungsebene mit einem zweiten Zwischendielektrikum oberhalb des ersten Zwischendielektrikums gefüllt ist. So lassen sich mehrere Metallisierungsschichten mit dazwischenliegenden Dielektrika übereinander stapeln.

Gemäß einer weiteren bevorzugten Weiterbildung weist die Halbleiterstruktur eine in einem Siliziumsubstrat integrierte elektrische Schaltung auf.

Gemäß einer weiteren bevorzugten Weiterbildung wird die Linerschicht aus Siliziumdioxid oder Siliziumnitrid hergestellt ist.

Gemäß einer weiteren bevorzugten Weiterbildung werden die erste und/oder zweite Metallisierungsebene aus AlCu hergestellt.

Gemäß einer weiteren bevorzugten Weiterbildung werden das Strukturieren und Unterbrechen in einem gemeinsamen Ätzschritt durchgeführt. Dafür ist lediglich die Auswahl eines geeigneten Ätzmittels bzw. einer geeigneten Liner/Metall-Kombination erforderlich. Dann bedarf es im Vergleich zum üblichen Prozeß lediglich einer längeren Ätzzeit, jedoch keiner zusätzlichen Maskenebene bzw. keines zusätzlichen Ätzschrittes.

Gemäß einer weiteren bevorzugten Weiterbildung wird das Strukturieren in einem ersten Metall-Ätzschritt und wird das Unterbrechen in einem zweiten Siliziumdioxid-Ätzschritt durchgeführt.

Gemäß einer weiteren bevorzugten Weiterbildung wird für das Strukturieren und Unterbrechen eine Hartmaske oder eine Lackmaske verwendet, die auf der zweiten Metallisierungsebene vorgesehen wird.

Ein Ausführungsbeispiel der Erfindung ist in den Zeichnungen dargestellt und in der nachfolgenden Beschreibung näher erläutert.
- Fig. 1a-h: zeigen eine schematische Darstellung der wesentlichen Verfahrensschritte zur Herstellung einer Metallisierungsanordnung für eine Halbleiterstruktur als Ausführungsform der vorliegenden Erfindung; und
- Fig. 2: zeigen eine schematische Darstellung einer bekannten Metallisierungsanordnung für eine Halbleiterstruktur.

In den Figuren bezeichnen gleiche Bezugszeichen gleiche oder funktionsgleiche Elemente.

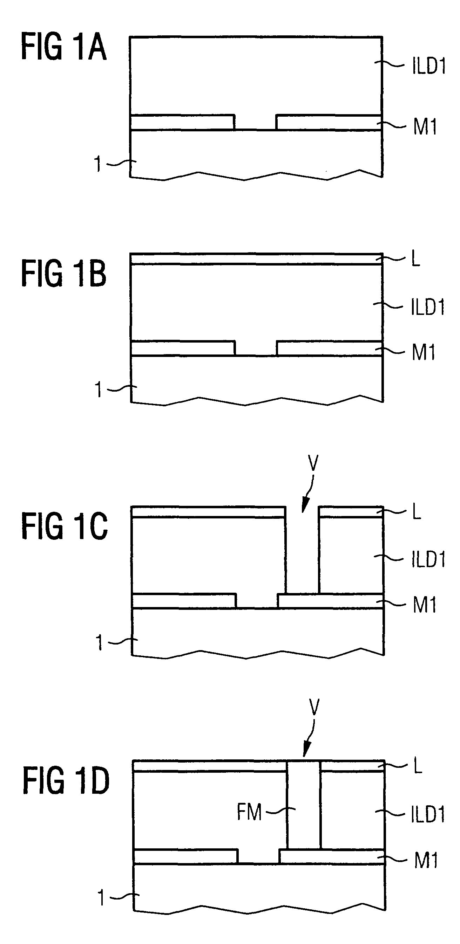

Fig. 1a-h zeigen eine schematische Darstellung der wesentlichen Verfahrensschritte zur Herstellung einer Metallisierungsanordnung für eine Halbleiterstruktur als Ausführungsform der vorliegenden Erfindung.

Wie in Figur 1a dargestellt, erfolgt zunächst die Abscheidung und Strukturierung der ersten Metallisierungsschicht M1 auf der Halbleiterstruktur 1. Daraufhin wird ganzflächig ein Zwischendielektrikum ILD1 auf der resultierenden Struktur abgeschieden. Dieses Zwischendielektrikum ILD1 mit geringer Dielektrizitätskonstante ist beispielsweise eine kohlenstoffhaltige SiO₂-Schicht.

Gemäß Figur 1b wird in einem folgenden Prozessschritt eine Linerschicht L auf die resultierende Struktur aufgebracht. Dazu sei bemerkt, dass die Dielektrizitätskonstante der Linerschicht L größer ist als die Dielektrizitätskonstante des Zwischendielektrikums ILD1.

Es folgt eine Strukturierung der Linerschicht L und des Zwischendielektrikums ILD1 mittels einer standardmäßigen photolithografischen Technik. Dadurch wird das Durchgangsloch V geschaffen, wie in Figur 1c dargestellt.

In einem weiteren Prozessschritt, wie in Figur 1d illustriert, wird das Durchgangsloch V dann mit dem leitenden Füllmaterial FM aufgefüllt.

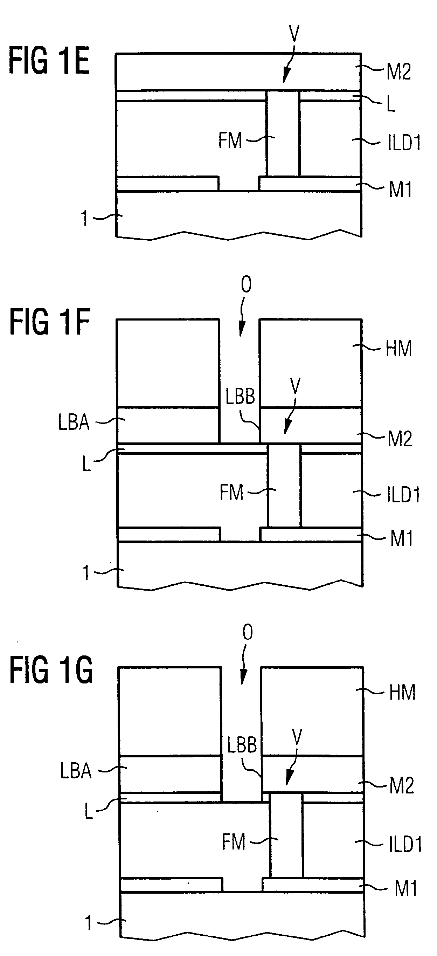

Danach oder im selben Prozessschritt wird dann eine zweite Metallisierungsschicht M2 abgeschieden, was zur in Figur 1e gezeigten Struktur führt.

Daraufhin wird auf der zweiten Metallisierungsschicht M2 eine Photolackmaske oder, wie im vorliegenden Beispiel, eine Hartmaske beispielsweise aus Siliziumnitrid, vorgesehen. Mittels der Hartmaske HM wird die zweite Metallisierungsschicht M2 in die Leiterbahnen LBA und LBB strukturiert. Dies ist in Figur 1f illustriert.

Entweder im selben Ätzschritt oder in einem zusätzlichen Ätzschritt mit anderem Ätzmedium wird dann die freigelegte Linerschicht L weggeätzt, so dass sich in dem Zwischenraum O kein Liner und auch kein Metall mehr befindet. Dies ist in Figur 1g dargestellt. Somit ist die Metallstruktur in die Linerschicht L aus Siliziumdioxid übertragen. Bei geeigneter Auswahl der Linerschicht 6 und des Ätzmediums erfordert dies lediglich eine Verlängerung des bekannten Ätzprozesses für die Metallisierungsschicht M2.

Gemäß der in Figur 1h dargestellten Struktur erfolgt dann ein Entfernen der Hartmaske HM und eine Abscheidung einer weiteren Zwischendielektrikumsschicht ILD2. Auf diesem weiteren Zwischendielektrikum ILD2 kann dann entweder eine abschließende Passivierungsschicht oder eine weitere dritte Metallisierungsschicht usw. aufgetragen werden.

Wie aus Figur 1h klar erkennbar, ist durch diese Art der Prozessführung die Linerschicht L aus Siliziumdioxid überall dort entfernt, wo auch die Metallschicht M2 entfernt ist, so-dass die störenden kapazitiven Koppelungseffekte beseitigt sind.

Obwohl die vorliegende Erfindung vorstehend anhand eines bevorzugten Ausführungsbeispiels beschrieben wurde, ist sie darauf nicht beschränkt, sondern auf vielfältige Art und Weise modifizierbar.

Selbstverständlich ist die vorliegende Erfindung auf beliebige Halbleiterstrukturen, insbesondere integrierte Schaltungen, und beliebige Halbleiter-Grundmaterialien anwendbar, insbesondere kann man beliebige Halbleitermaterialien bzw. Materialien-Sandwiches als Substrat verwenden.

Obwohl beim obigen Beispiel die erste Unterbauebene eine Metallisierungsebene ist, kann sie auch eine andere Ebene sein, also die Erfindung für die unterste Metallisierungsebene angewendet werden.

### Bezugszeichenliste

Metallisierungsanordnung für Halbleiterstruktur und entsprechendes Herstellungsverfahren
- 1: Halbleiterstruktur
- ILD, ILD1, ILD2: Zwischendielektrikum
- M1, M2: Metallisierungsebene
- L, L1, L2: Linerschicht
- FM: leitendes Füllmaterial
- V: Durchgangsloch
- O: Zwischenraum
- LBA, LBB: Leiterbahn in M2
- K: kritische Stellen

## Patentansprüche

1. Metallisierungsanordnung für eine Halbleiterstruktur (1) mit:
einer ersten Unterbauebene (M1);
einer zweiten Metallisierungsebene (M2) mit einer ersten und
einer zweiten benachbarten Leiterbahn (LBA; LBB);
einem ersten Zwischendielektrikum (ILD1) zur gegenseitigen elektrischen Isolation der ersten Unterbauebene (M1) und
zweiten Metallisierungsebene (M2); und
mit einem leitenden Material (FM) gefüllten Durchgangslöchern (V) in dem Zwischendielektrikum (ILD1) zum Verbinden der ersten Unterbauebene (M1) und zweiten Metallisierungsebene (M2) ;
wobei unter der zweiten Metallisierungsebene (M2) eine Linerschicht (L) aus einem dielektrischen Material vorgesehen ist, welche im Zwischenraum (O) zwischen der ersten und zweiten benachbarten Leiterbahn (LBA; LBB) der zweiten Metallisierungsebene (M2) unterbrochen ist.

2. Metallisierungsanordnung nach Anspruch 1,
**dadurch gekennzeichnet,**
**dass** die erste Unterbauebene (M1) eine erste Metallisierungsebene ist.

3. Metallisierungsanordnung nach Anspruch 1 oder 2,
**dadurch gekennzeichnet**,
der Zwischenraum (O) zwischen der ersten und zweiten benachbarten Leiterbahn (LBA; LBB) der zweiten Metallisierungsebene (M2) mit einem zweiten Zwischendielektrikum (ILD2) oberhalb des ersten Zwischendielektrikums (ILD1) gefüllt ist.

4. Metallisierungsanordnung nach Anspruch 1, 2 oder 3,
**dadurch gekennzeichnet,**
**dass** die Halbleiterstruktur eine in einem Siliziumsubstrat integrierte elektrische Schaltung aufweist.

5. Metallisierungsanordnung nach einem der Ansprüche 1 bis 4,
**dadurch gekennzeichnet,**
**dass** die Linerschicht (L) aus Siliziumdioxid oder Siliziumnitrid hergestellt ist.

6. Metallisierungsanordnung nach einem der Ansprüche 2 bis 4,
**dadurch gekennzeichnet,**
**dass** die erste und/oder zweite Metallisierungsebene (M1; M2) aus AlCu hergestellt sind.

7. Verfahren zum Herstellen einer Metallisierungsanordnung für eine Halbleiterstruktur (1) mit den Schritten:
Vorsehen einer ersten Unterbauebene (M1), vorzugsweise einer ersten Metallisierungsebene, auf der Halbleiterstruktur (1); Vorsehen eines ersten Zwischendielektrikums (ILD1) auf der ersten Unterbauebene (M1);
Vorsehen einer Linerschicht (L) aus einem dielektrischen Material auf der ersten Unterbauebene (M1);
Vorsehen von mit einem leitenden Material (FM) gefüllten Durchgangslöchern (V) in dem ersten Zwischendielektrikum (ILD1) und der Linerschicht (L);
Vorsehen einer zweiten Metallisierungsebene (M2) auf der resultierenden Struktur;
Strukturieren einer ersten und einer zweiten benachbarten Leiterbahn (LBA; LBB) in der zweiten Metallisierungsebene (M2); und Unterbrechen der Linerschicht im Zwischenraum (O) zwischen der ersten und zweiten benachbarten Leiterbahn (LBA; LBB) der zweiten Metallisierungsebene (M2).

8. Verfahren nach Anspruch 7,
**dadurch gekennzeichnet,**
**dass** das Strukturieren und Unterbrechen in einem gemeinsamen Ätzschritt durchgeführt werden.

9. Verfahren nach Anspruch 7 oder 8,
**dadurch gekennzeichnet,**
**dass** die Halbleiterstruktur eine in einem Siliziumsubstrat integrierte elektrische Schaltung aufweist.

10. Verfahren nach Anspruch 9,
**dadurch gekennzeichnet,**
**dass** die Linerschicht (L) aus Siliziumdioxid oder Siliziumnitrid hergestellt wird.

11. Verfahren nach Anspruch 10,
**dadurch gekennzeichnet,**
**dass** das Strukturieren in einem ersten Metall-Ätzschritt und das Unterbrechen in einem zweiten Siliziumdioxid-Ätzschritt durchgeführt wird.

12. Verfahren nach einem der Ansprüche 7 bis 11,
**dadurch gekennzeichnet,**
**dass** der Zwischenraum (O) zwischen der ersten und zweiten benachbarten Leiterbahn (LBA; LBB) der zweiten Metallisierungsebene (M2) mit einem zweiten Zwischendielektrikum (ILD2) oberhalb des ersten Zwischendielektrikums (ILD1) gefüllt wird.

13. Verfahren nach einem der Ansprüche 7 bis 12,
**dadurch gekennzeichnet,**
**dass** für das Strukturieren und Unterbrechen eine Hartmaske oder eine Lackmaske verwendet wird, die auf der zweiten Metallisierungsebene (M2) vorgesehen wird.
